# EUROPEAN PATENT SPECIFICATION

(11) **EP 3 493 922 B1**
(45) Date of publication and mention of the grant of the patent: **22.12.2021**
(21) Application number: 17837522.6
(22) Date of filing: 01.08.2017
(51) Int. Cl.: H01L 33/50, C09K 11/02

(54) **COATED WAVELENGTH CONVERTING NANOPARTICLES AND METHOD OF MANUFACTURUNG THE SAME**
BESCHICHTETE WELLENLÄNGENUMWANDLUNGSNANOPARTIKEL UND VERFAHREN ZU DEREN HERSTELLUNG
NANOPARTICULES REVÊTUES DE CONVERSION DE LONGUEUR D'ONDE ET PROCÉDÉ DE SA FABRICATION

(30) Priority: 03.08.2016 US 201662370618 P; 05.10.2016 EP 16192411; 31.07.2017 US 201715664270
(43) Date of publication of application: 12.06.2019
(73) Proprietor: Lumileds LLC, San Jose, CA 95131 (US)
(72) Inventor: SHIMIZU, Kentaro, San Jose California 95131 (US); ROITMAN, Daniel, San Jose California 95131 (US); BOHMER, Marcel, 52068 Aachen (DE); PATEL, Amil, San Jose California 95131 (US); ESTRADA, Daniel, 52068 Aachen (DE)
(74) Representative: EDP Patent Attorneys B.V.
(86) International application number: PCT/US2017/044852
(87) International publication number: WO 2018/026789

(56) References cited:
- WO-A1-2016/104401
- US-A1- 2010 261 263
- US-A1- 2014 264 196
- US-A1- 2014 264 196
- US-A1- 2015 011 029
- US-A1- 2015 203 747
- US-A1- 2015 344 776
- US-A1- 2016 141 463

## Description

### BACKGROUND

Semiconductor light-emitting devices including light emitting diodes (LEDs), resonant cavity light emitting diodes (RCLEDs), vertical cavity laser diodes (VCSELs), and edge emitting lasers are among the most efficient light sources currently available. Materials systems currently of interest in the manufacture of high-brightness light emitting devices capable of operation across the visible spectrum include Group III-V semiconductors, particularly binary, ternary, and quaternary alloys of gallium, aluminum, indium, and nitrogen, also referred to as III-nitride materials. Typically, III-nitride light emitting devices are fabricated by epitaxially growing a stack of semiconductor layers of different compositions and dopant concentrations on a sapphire, silicon carbide, III-nitride, or other suitable substrate by metal-organic chemical vapor deposition (MOCVD), molecular beam epitaxy (MBE), or other epitaxial techniques. The stack often includes one or more n-type layers doped with, for example, Si, formed over the substrate, one or more light emitting layers in an active region formed over the n-type layer or layers, and one or more p-type layers doped with, for example, Mg, formed over the active region. Electrical contacts are formed on the n- and p-type regions.

LEDs that emit blue light are often combined with luminescent material which converts a part of the blue light into light of another color of a longer wavelength; for example, to yellow, orange or red light. Often, not all blue light is converted, such that the combined converted and unconverted light appears white. The amount of luminescent material and the characteristics of the luminescent material are chosen such that a required amount of blue light is converted towards a specific amount of light of one or more other colors, such that the combined emission of remaining blue light and the specific amounts of light of the other colors combine and appear white. The color point of the combined converted and unconverted light is, in some embodiments, preferably close to or on the black body line in a color space.

US 2015/011029 A1 describes networks of semiconductor structures with fused insulator coatings and methods of fabricating networks of semiconductor structures with fused insulator coatings. In an example, a method of fabricating a semiconductor structure involves forming a mixture including a plurality of discrete semiconductor nanocrystals. Each of the plurality of discrete semiconductor nanocrystals is discretely coated by an insulator shell.

US 2014/264196 A1 describes coated beads made of a primary matrix material and containing a population of quantum dot nanoparticles. Each bead has a multi-layer surface coating. The layers can be two or more distinct surface coating materials. The surface coating materials may be inorganic materials and/or polymeric materials. A method of preparing such particles is also described. The coated beads are useful for composite materials for applications such as light-emitting devices.

### BRIEF DESCRIPTION OF THE DRAWINGS

Fig. 1 is a cross sectional view of a coated nanoparticle according to some embodiments.
Fig. 2 illustrates a core/shell nanoparticle.
Fig. 3 illustrates operations in a reverse micelle approach to coating a core/shell nanoparticle with a second shell.
Fig. 4 illustrates a method of forming a protective coating on a nanoparticle.
Fig. 5 illustrates a method of forming a second protective coating on a nanoparticle.
Fig. 6 illustrates a light source including coated nanoparticles according to some embodiments.

### DETAILED DESCRIPTION

Luminescent materials are preferably tunable, and emit light with a narrow peak; for example, with a full width half maximum (FWHM) of no more than 40 nm. Direct bandgap semiconducting nanoparticles are one example of a suitable tunable and narrow luminescent material. The peak emission wavelength of the nanoparticles can be controlled by appropriately selecting the size of the nanoparticles. Peak emission wavelengths across the visible spectrum are possible. The narrow size distribution of nanoparticles may result in a narrow FWHM, as low as 20 nm in some embodiments.

"Nanoparticles," as used herein, refers to particles that show quantum confinement and have, in at least one dimension, a size in the nanometer range. "Quantum confinement" means that the particles have optical properties that depend on the size of the particles. Though such nanoparticles may be referred to herein as "quantum dots" for economy of language, any suitable nanoparticle may be used, including, for example, quantum dots, quantum rods, and quantum tetrapods. Embodiments of the invention are not limited to quantum dots. As used herein, "nanoparticle" or "quantum dot" may refer to a portion of a particle (i.e., the core described below), or the entire particle (i.e., the core, shell, second shell, and/or coating described below).

One consistent problem with quantum dots is their susceptibility to moisture. Although high quantum efficiency is observed in an inert or dry atmosphere, the photothermal stability of many quantum dots is degraded in the presence of high humidity.

The invention provides a method comprising forming, by atomic layer deposition, a coating of a metal oxide on a plurality of particles showing quantum confinement and having a size in the nanometer range in at least one dimension, as further defined in the accompanying claims. Embodiments of the invention are directed to methods for coating nanoparticles such as quantum dots. Coatings produced by some embodiments may reduce the susceptibility of the nanoparticles to moisture, which may improve the performance of a device including the coated nanoparticles.

The invention further provides a luminescent material comprising particles comprising a semi-permeable coating, as further defined in the accompanying claims. In yet a further aspect, the invention (also) provides a device comprising a light emitting diode (LED) and the luminescent material disposed in a path of light emitted by the LED.

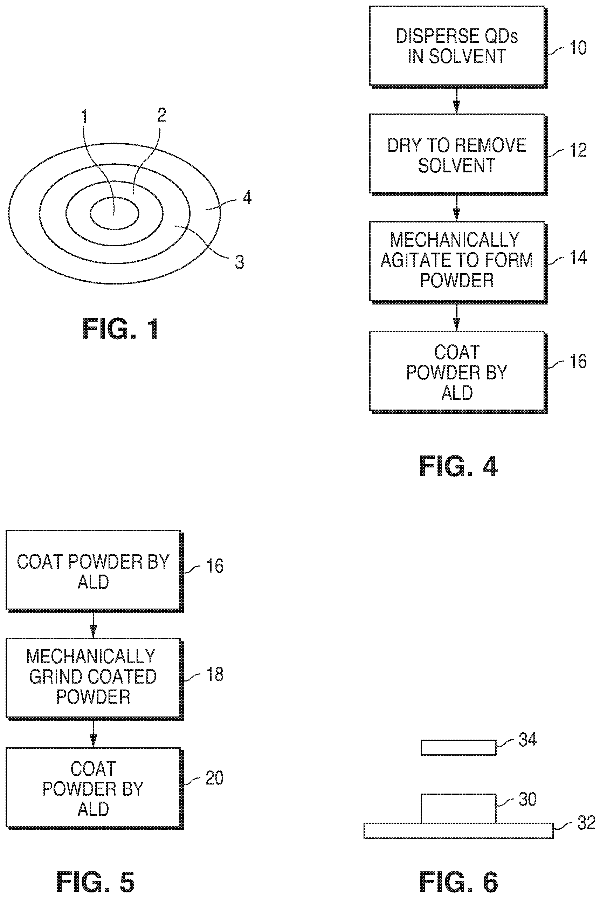

Fig. 1 is a cross sectional view of a single nanoparticle including a coating according to some embodiments. At the center of the nanoparticle in Fig. 1 is a quantum dot 1, which is a semiconducting material.

A shell 2, also a semiconducting material, and often a different material from quantum dot 1, surrounds quantum dot 1. The structure including quantum dot 1 and shell 2 is often referred to as a "core/shell" nanocrystal and is known in the art. The shell 2 may increase the quantum yield of the core/shell structure by passivating the surface trap states. In addition, the shell 2 may provide some protection against environmental changes and photo-oxidative degradation. The core 1 and the shell 2 are often type II-VI, IV-VI, and/or III-V semiconductors. Any suitable core/shell material may be used in embodiments of the invention. Examples of suitable core/shell structures include CdS/ZnS, CdSe/ZnS, CdSe/CdS, and InAs/CdSe. Cadmium free quantum dots 1 such as indium phosphode (InP), and copper indium sulfide (CuInS₂) and/or silver indium sulfide (AgInS₂) may also be used. Other suitable materials may include ZnSe/ZnS, CdTe/ZnS, PbS/ZnS, PbSe/ZnS, HgTe/ZnS, and alloy materials, including, for example, InGaP/ZnS and InZnP/ZnS.

In some embodiments, the semiconductor shell 2 is covered with a second shell 3. Shell 3 may be, for example, an insulator, an insulating oxide, aluminum oxide, silicon oxide, zirconium oxide, titanium oxide, zinc oxide, hafnium oxide, niobium oxide, silica, or any other suitable material. Second shell 3 may fully or only partially cover shell 2.

According to embodiments of the invention, a protective coating 4 is formed over the second shell 3. Protective coating 4 may prevent moisture from reaching core 1/shell 2, or may reduce the amount of moisture that reaches core 1/shell 2. Any suitable material may be used, including, for example, metal oxide, Al₂O₃, SiO₂, Nb₂O₅, a multilayer structure, and a multilayer of Al₂O₃ and Nb₂O₅. A multilayer structure may include, for example, layer pairs of first and second materials, where the first and second materials alternate, and there are at least two or more layer pairs. Examples of suitable first and second materials include Al₂O₃ and Nb₂O₅. Other suitable materials for multilayer structures include, for example, ZrO₂, TiO₂, Ta₂O₅, or HfO₂. Multilayer coatings may be more robust coatings than single layers, for example by reducing oxygen or water migration. Protective coating 4 may be at least 10 nm thick in some embodiments and no more than 50 nm thick in some embodiments. Protective coating 4 may fully or only partially cover second shell 3, or shell 2, in embodiments where second shell 3 is omitted.

Forming the protective coating 4 is described below in the text accompanying Figs. 4 and 5. In some embodiments, second shell 3 is omitted and protective coating 4 is formed directly on core/shell particles including core 1 and shell 2.

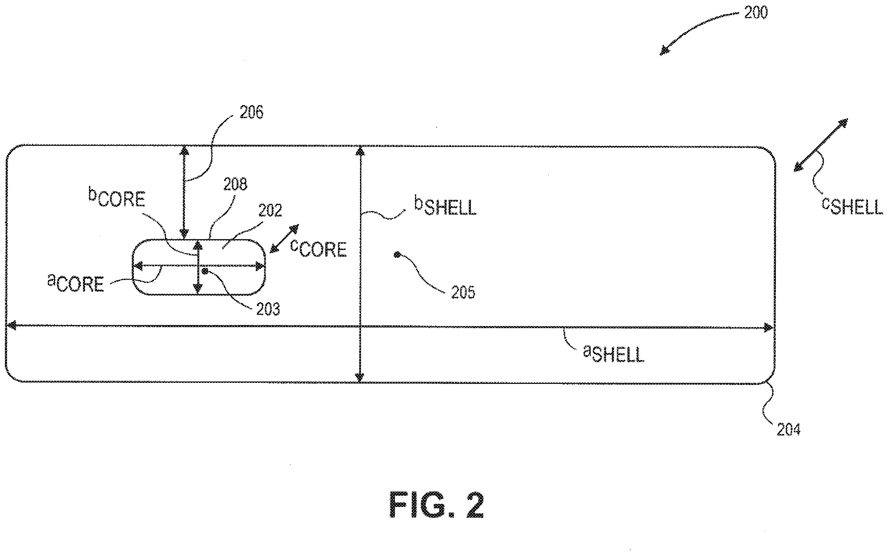

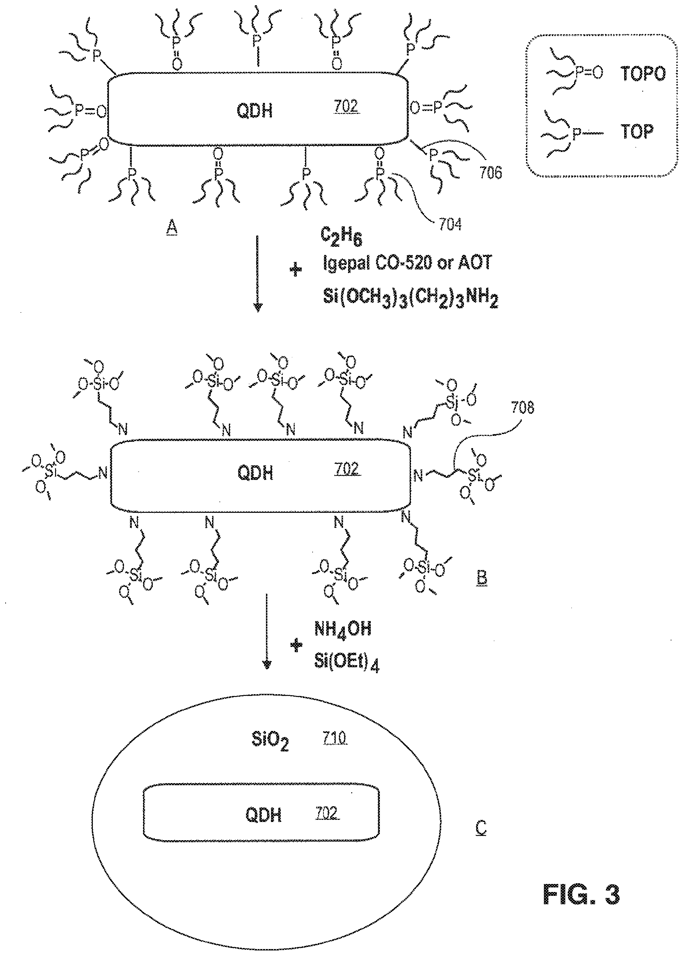

Particles including core 1 and shell 2, or including core 1, shell 2, and second, often silica, shell 3, may be formed as described in WO2013/070321. Figs. 2 and 3 and accompanying text are adapted from WO 2013/070321. In the discussion of Figs. 2 and 3, core 1 is referred to as a core, shell 2 is referred to as a shell, and silica shell 3 is referred to as an insulator layer or a silica layer.

Fig. 2 illustrates a schematic of a cross-sectional view of a quantum dot and shell. Several factors may be intertwined for establishing an optimized geometry for a quantum dot having a nanocrystalline core and nanocrystalline shell pairing. Referring to Figure 2, a semiconductor structure (e.g., a quantum dot structure) 200 includes a nanocrystalline core 202 surrounded by a nanocrystalline shell 204. The nanocrystalline core 202 has a length axis (a_{CORE}), a width axis (b_{CORE}) and a depth axis (C_{CORE}), the depth axis provided into and out of the plane shown in Fig. 2. Likewise, the nanocrystalline shell 204 has a length axis (a_{SHELL}), a width axis (b_{SHELL}) and a depth axis (C_{SHELL}), the depth axis provided into and out of the plane shown in Fig. 2. The nanocrystalline core 202 has a center 203 and the nanocrystalline shell 204 has a center 205. The nanocrystalline shell 204 surrounds the nanocrystalline core 202 in the b-axis direction by an amount 206, as is also depicted in Figure 2.

The following are attributes of a quantum dot that may be tuned for optimization, with reference to the parameters provided in Fig. 2. Nanocrystalline core 202 diameter (a, b or c) and aspect ratio (e.g., a/b) can be controlled for rough tuning for emission wavelength (a higher value for either providing increasingly red emission). A smaller overall nanocrystalline core provides a greater surface to volume ratio. The width of the nanocrystalline shell along 206 may be tuned for yield optimization and quantum confinement providing approaches to control red-shifting and mitigation of surface effects. However, strain considerations must be accounted for when optimizing the value of thickness 206. The length (a_{SHELL}) of the shell is tunable to provide longer radiative decay times as well as increased light absorption. The overall aspect ratio of the structure 200 (e.g., the greater of a_{SHELL} /b_{SHELL} and a_{SHELL}/c_{SHELL}) may be tuned to directly impact photoluminescence quantum yield (PLQY). Meanwhile, overall surface/volume ratio for 200 may be kept relatively smaller to provide lower surface defects, provide higher photoluminescence, and limit self-absorption. Referring again to Fig. 2, the shell/core interface 207 may be tailored to avoid dislocations and strain sites. In one such embodiment, a high quality interface is obtained by tailoring one or more of injection temperature and mixing parameters, the use of surfactants, and control of the reactivity of precursors, as is described in greater detail below.

A high PLQY quantum dot may be based on a core/shell pairing using an anisotropic core. With reference to Fig. 2, an anisotropic core is a core having one of the axes a_{CORE}, b_{CORE} or c_{CORE} different from one or both of the remaining axes. An aspect ratio of such an anisotropic core is determined by the longest of the axes a_{CORE}, b_{CORE} or c_{CORE} divided by the shortest of the axes a_{CORE}, b_{CORE} or c_{CORE} to provide a number greater than 1 (an isotropic core has an aspect ratio of 1). It is to be understood that the outer surface of an anisotropic core may have rounded or curved edges (e.g., as in an ellipsoid) or may be faceted (e.g., as in a stretched or elongated tetragonal or hexagonal prism) to provide an aspect ratio of greater than 1 (note that a sphere, a tetragonal prism, and a hexagonal prism are all considered to have an aspect ratio of 1).

One suitable semiconductor structure includes an anisotropic nanocrystalline core composed of a first semiconductor material and having an aspect ratio between 1.0 and 2.0. The semiconductor structure also includes a nanocrystalline shell composed of a second, different, semiconductor material at least partially surrounding the anisotropic nanocrystalline core. In one such embodiment, the aspect ratio of the anisotropic nanocrystalline core is approximately in the range of 1.01 - 1.2 and, in a particular embodiment, is approximately in the range of 1.1 - 1.2. In the case of rounded edges, then, the nanocrystalline core may be substantially, but not perfectly, spherical. However, the nanocrystalline core may instead be faceted. In an embodiment, the anisotropic nanocrystalline core is disposed in an asymmetric orientation with respect to the nanocrystalline shell.

Another consideration for maximization of PLQY in a quantum dot structure is to provide an asymmetric orientation of the core within a surrounding shell. For example, referring again to Fig. 2, the center 203 of the core 202 may be misaligned with (e.g., have a different spatial point than) the center 205 of the shell 202. In an embodiment, a semiconductor structure includes an anisotropic nanocrystalline core composed of a first semiconductor material. The semiconductor structure also includes a nanocrystalline shell composed of a second, different, semiconductor material at least partially surrounding the anisotropic nanocrystalline core. The anisotropic nanocrystalline core is disposed in an asymmetric orientation with respect to the nanocrystalline shell. In one such embodiment, the nanocrystalline shell has a long axis (e.g., a_{SHELL}), and the anisotropic nanocrystalline core is disposed off-center along the long axis. In another such embodiment, the nanocrystalline shell has a short axis (e.g., b_{SHELL}), and the anisotropic nanocrystalline core is disposed off-center along the short axis. In yet another embodiment, however, the nanocrystalline shell has a long axis (e.g., a_{SHELL}) and a short axis (e.g., b_{SHELL}), and the anisotropic nanocrystalline core is disposed off-center along both the long and short axes.

With reference to the above described nanocrystalline core and nanocrystalline shell pairings, in an embodiment, the nanocrystalline shell completely surrounds the anisotropic nanocrystalline core. In an alternative embodiment, however, the nanocrystalline shell only partially surrounds the anisotropic nanocrystalline core, exposing a portion of the anisotropic nanocrystalline core, e.g., as in a tetrapod geometry or arrangement. In an embodiment, the nanocrystalline shell is an anisotropic nanocrystalline shell, such as a nano-rod, that surrounds the anisotropic nanocrystalline core at an interface between the anisotropic nanocrystalline shell and the anisotropic nanocrystalline core. The anisotropic nanocrystalline shell passivates or reduces trap states at the interface. The anisotropic nanocrystalline shell may also, or instead, deactivate trap states at the interface.

With reference again to the above described nanocrystalline core and nanocrystalline shell pairings, in an embodiment, the first and second semiconductor materials (core and shell, respectively) are each materials such as, but not limited to, Group II-VI materials, Group III-V materials, Group IV- VI materials, Group I-IΠ-VI materials, or Group II- IV-VI materials and, in one embodiment, are monocrystalline. In one such embodiment, the first and second semiconductor materials are both Group Π-VI materials, the first semiconductor material is cadmium selenide (CdSe), and the second semiconductor material is one such as, but not limited to, cadmium sulfide (CdS), zinc sulfide (ZnS), or zinc selenide (ZnSe). In an embodiment, the semiconductor structure further includes a nanocrystalline outer shell at least partially surrounding the nanocrystalline shell and, in one embodiment, the nanocrystalline outer shell completely surrounds the nanocrystalline shell. The nanocrystalline outer shell is composed of a third semiconductor material different from the first and second semiconductor materials. In a particular such embodiment, the first semiconductor material is cadmium selenide (CdSe), the second semiconductor material is cadmium sulfide (CdS), and the third semiconductor material is zinc sulfide (ZnS).

With reference again to the above described nanocrystalline core and nanocrystalline shell pairings, in an embodiment, the semiconductor structure (i.e., the core/shell pairing in total) has an aspect ratio approximately in the range of 1.5 - 10 and, 3-6 in a particular embodiment. In an embodiment, the nanocrystalline shell has a long axis and a short axis. The long axis has a length approximately in the range of 5 - 40 nanometers. The short axis has a length approximately in the range of 1 - 5 nanometers greater than a diameter of the anisotropic nanocrystalline core parallel with the short axis of the nanocrystalline shell. In a specific such embodiment, the anisotropic nanocrystalline core has a diameter approximately in the range of 2 - 5 nanometers. In another embodiment, the anisotropic nanocrystalline core has a diameter approximately in the range of 2 - 5 nanometers. The thickness of the nanocrystalline shell on the anisotropic nanocrystalline core along a short axis of the nanocrystalline shell is approximately in the range of 1 - 5 nanometers of the second semiconductor material.

There are various synthetic approaches for fabricating CdSe quantum dots. For example, in an embodiment, under an inert atmosphere (e.g., ultra high purity (UHP) argon), cadmium oxide (CdO) is dissociated in the presence of surfactant (e.g., octadecylphosphonic acid (ODPA)) and solvent (e.g., trioctylphosphine oxide (TOPO); triocytlphosphine (TOP)) at high temperatures (e.g., 350 - 380 degrees Celsius). Resulting Cd²⁺ cations are exposed by rapid injection to solvated selenium anions (Se²⁻), resulting in a nucleation event forming small CdSe seeds. The seeds continue to grow, feeding off of the remaining Cd²⁺ and Se²⁻ available in solution, with the resulting quantum dots being stabilized by surface interactions with the surfactant in solution (ODPA). The aspect ratio of the CdSe seeds is typically between 1 and 2, as dictated by the ratio of the ODPA to the Cd concentration in solution. The quality and final size of these cores is affected by several variables such as, but not limited to, reaction time, temperature, reagent concentration, surfactant concentration, moisture content in the reaction, or mixing rate. The reaction is targeted for a narrow size distribution of CdSe seeds (assessed by transmission electron microscopy (TEM)), typically a slightly cylindrical seed shape (also assessed by TEM) and CdSe seeds exhibiting solution stability over time (assessed by PLQY and scattering in solution).

For the cadmium sulfide (CdS) shell growth on the CdSe seeds, or nanocrystalline cores, under an inert atmosphere (e.g. UHP argon), cadmium oxide (CdO) is dissociated in the presence of surfactants (e.g., ODPA and hexylphosphonic acid (HPA)) and solvent (e.g. TOPO and/or TOP) at high temperatures (e.g., 350 - 380 degrees Celsius). The resulting Cd²⁺ cations in solution are exposed by rapid injection to solvated sulfur anions (S²⁻) and CdSe cores. Immediate growth of the CdS shell around the CdSe core occurs. The use of both a short chain and long chain phosphonic acid promotes enhanced growth rate at along the c- axis of the structure, and slower growth along the a-axis, resulting in a rod-shaped core/shell nanomaterial.

CdSe/CdS core-shell quantum dots have been shown in the literature to exhibit respectable quantum yields (e.g., 70 - 75%). However, the persistence of surface trap states (which decrease overall photoluminescent quantum yield) in these systems arises from a variety of factors such as, but not limited to, strain at the core-shell interface, high aspect ratios (ratio of rod length to rod width of the core/shell pairing) which lead to larger quantum dot surface area requiring passivation, or poor surface stabilization of the shell.

In order to address the above synthetic limitations on the quality of quantum dots formed under conventional synthetic procedures, in an embodiment, a multi-faceted approach is used to mitigate or eliminate sources of surface trap states in quantum dot materials. For example, lower reaction temperatures during the core/shell pairing growth yields slower growth at the CdSe - CdS interface, giving each material sufficient time to orient into the lowest-strain positions. Aspect ratios are controlled by changing the relative ratios of surfactants in solution as well as by controlling temperature. Increasing an ODPA/HPA ratio in reaction slows the rapid growth at the ends of the core/shell pairings by replacing the facile HPA surfactant with the more obstructive ODPA surfactant. In addition, lowered reaction temperatures are also used to contribute to slowed growth at the ends of the core/shell pairings. By controlling these variables, the aspect ratio of the core/shell pairing is optimized for quantum yield. In one such embodiment, following determination of optimal surfactant ratios, overall surfactant concentrations are adjusted to locate a PLQY maximum while maintaining long-term stability of the fabricated quantum dots in solution. Furthermore, in an embodiment, aspect ratios of the seed or core (e.g., as opposed to the seed/shell pairing) are limited to a range between, but not including 1.0 and 2.0 in order to provide an appropriate geometry for high quality shell growth thereon.

In another aspect, an additional or alternative strategy for improving the interface between CdSe and CdS includes, in an embodiment, chemically treating the surface of the CdSe cores prior to reaction. CdSe cores are stabilized by long chain surfactants (ODPA) prior to introduction into the CdS growth conditions. Reactive ligand exchange can be used to replace the ODPA surfactants with ligands which are easier to remove (e.g., primary or secondary amines), facilitating improved reaction between the CdSe core and the CdS growth reagents.

In a general embodiment, a semiconductor structure includes a nanocrystalline core composed of a first semiconductor material. The semiconductor structure also includes a nanocrystalline shell composed of a second, different, semiconductor material at least partially surrounding the nanocrystalline core. An insulator layer encapsulates, e.g., coats, the nanocrystalline shell and nanocrystalline core. Thus, coated semiconductor structures include coated structures such as the quantum dots described above. For example, in an embodiment, the nanocrystalline core is anisotropic, e.g., having an aspect ratio between, but not including, 1.0 and 2.0. In another example, in an embodiment, the nanocrystalline core is anisotropic and is asymmetrically oriented within the nanocrystalline shell. In an embodiment, the nanocrystalline core and the nanocrystalline shell form a quantum dot.

With reference again to the above described coated nanocrystalline core and nanocrystalline shell pairings, in an embodiment, the insulator layer is composed of a layer of material such as, but not limited to, silica (SiOₓ), titanium oxide (TiOₓ), zirconium oxide (ZrOₓ), alumina (AlOₓ), or hafnia (HfOₓ). In one such embodiment, the layer is a layer of silica having a thickness approximately in the range of 3 - 30 nanometers. In an embodiment, the insulator layer is an amorphous layer.

In an embodiment, a layer of silica is formed using a reverse micelle sol-gel reaction. In one such embodiment, using the reverse micelle sol-gel reaction includes dissolving the nanocrystalline shell/nanocrystalline core pairing in a first non-polar solvent to form a first solution. Subsequently, the first solution is added along with a species such as, but not limited to, 3-aminopropyltrimethoxysilane (APTMS), 3-mercapto-trimethoxysilane, or a silane comprising a phosphonic acid or carboxylic acid functional group, to a second solution having a surfactant dissolved in a second non-polar solvent. Subsequently, ammonium hydroxide and tetraorthosilicate (TEOS) are added to the second solution.

Thus, semiconductor nanocrystals coated with silica may be made by a sol-gel reaction such as a reverse micelle method. As an example, Fig. 3 illustrates operations in a reverse micelle approach to coating a semiconductor structure, in accordance with an embodiment of the present invention. Referring to part A of Fig. 3, a quantum dot hetero structure (QDH) 702 (e.g., a nanocrystalline core/shell pairing) has attached thereto a plurality of TOPO ligands 704 and TOP ligands 706. Referring to part B, the plurality of TOPO ligands 704 and TOP ligands 706 are exchanged with a plurality of Si(OCH₃)₃(CH₂)₃NH₂ ligands 708. The structure of part B is then reacted with TEOS (Si(OEt)₄) and ammonium hydroxide (NH₄OH) to form a silica coating 710 surrounding the QDH 702, as depicted in part C of Fig. 3. Thus, a reverse micelle is formed after adding ammonium hydroxide and tetraethylorthosilicate (TEOS), the source for the silica coating. TEOS diffuses through the micelle and is hydrolyzed by ammonia to form a uniform SiO₂ shell on the surface of the quantum dot. This approach may offer great flexibility to incorporate quantum dots of different sizes. In one such embodiment, the thickness of the insulator layer formed depends on the amount of TEOS added to the second solution.

Upon initiation of growth of a silica shell, the final size of that shell may be directly related to the amount of TEOS in the reaction solution. Silica coatings according to embodiments of the present invention may be conformal to the core/shell QDH or nonconformal. A silica coating may be between about 3nm and 30 nm thick. The silica coating thickness along the c-axis may be as small as about 1 nm or as large as about 20 nm. The silica coating thickness along the a-axis may be between about 3nm and 30 nm. Once silica shelling is complete, the product is washed with solvent to remove any remaining ligands. The silica coated quantum dots can then be incorporated into a polymer matrix or undergo further surface functionalization. However, silica shells according to embodiments of the present invention may also be functionalized with ligands to impart solubility, dispersability, heat stability and photo-stability in the matrix.

Figs. 4 and 5 illustrate methods, according to embodiments of the invention, of forming the protective coating 4 of Fig. 1. As described above, the protective coating may be formed over second, often silica, shell 3, or over shell 2, in embodiments where silica shell 3 is omitted. Accordingly, the method illustrated in Fig. 4 begins with nanoparticles that include core 1 and shell 2, or nanoparticles that include core 1, shell 2, and second shell 3.

After growing second shell 3, a base may be added to the silica shell 3 to passivate any porosity of the surface of the nanoparticle. The nanoparticles are often in a solvent formulation but the nanoparticles can be dried into powder form after the silica shell has been grown.

In stage 10 of Fig. 4, the nanoparticles are dispersed in a solvent. The solvent may be, for example, a non-polar organic solvent such as cyclohexane.

In stage 12, the nanoparticles are dried, for example under a hotplate in a glove box, to remove all solvent content.

In stage 14, the dried nanoparticles are mechanically agitated or ground to form fine powders. For example, the dried nanoparticles may be ground in a particle grinder and mill such as a Retsch Mortar grinder mill. After grinding in stage 14, the particle sizes may vary from 500 nm to hundreds of microns depending on the degree of grinding. In some embodiments, a preferred particle size is between 1 and 25 µm, which may minimize excessive scattering, and which may be process compatible with dispensing tools. The shape of the particles maybe arbitrary but a sphere may be preferred, for example for ease of forming coating 4 and for ease of other, subsequent processing.

In stage 16, the powdered nanoparticles are coated with protective coating 4. Protective coating 4 may be applied by any suitable technique, including, for example, atomic layer deposition (ALD). Standard ALD equipment and processing may be used to form protective coating 4. For example, the particles may be placed in a cartridge that allows gas to flow in between the particles, but does not allow the particles to be lost or evacuated during thermally-assisted ALD. Mechanical agitation of the powder cartridge may also offer motion of the particles such that there are no uncoated surfaces due to contact between the particles. During thermally-assisted ALD, alternating gas precursors of the oxide material may be flushed sequentially. Examples of gas precursors include trimethylaluminum and tris(tertbutoxy) silanol and water. The gas mixture may be flushed with nitrogen between the sequence of trimethylaluminum and water.

In some embodiments, ALD growth of coating 4 allows the growth of coatings with different levels of permeability. For example, an Al₂O₃ coating 4 may provide a standard hermetic barrier. A multi-layer coating 4 of Al₂O₃ and Nb₂O₅ can be used to make a more robust hermetic barrier. An SiO₂ coating 4 may be made semi-permeable. Whether a coating is hermetic or semi-permeable may be measured by the water vapor transport rate (WVTR). WVTR may be measured by, for example, a MOCON tool, as is known in the art. A hermetic barrier may have a WVTR value below 10⁻⁵ g/m²/day. Such a hermetic barrier may provide a sufficient water barrier for applications such as Organic photovoltaic structures and organic LEDs. According to the invention, the semi-permeable or pseudo-hermetic barrier has a WVTR of between 10⁻¹ g/m²/day and 10⁻⁴ g/m²/day. Silicone encapsulation has a WVTR of greater than 8 g/m²/day, for comparison.

In some embodiments, after forming protective coating 4, the nanoparticles are again mechanically agitated or ground, for example to form a more uniform particle distribution. During this grinding operation, the particle size is preferably not significantly changed, but the particle size distribution may be reduced. In some embodiments, after forming coating 4, the particle size should be the same or slightly bigger, depending on if forming coating 4 leads to aggregation or fusing of neighboring particles. The particle size after forming coating 4, and/or after grinding after forming coating 4, may be at least 1 µm in some embodiments, and no more than 25 µm in some embodiments.

In some embodiments, a second protective coating may be applied, as illustrated in Fig. 5. In stage 16, a first protective coating 4 is formed, as described above in reference to Figs. 1 and 4.

In stage 18, the coated nanoparticles may be mechanically agitated or ground.

In stage 20, a second protective coating 4 is formed on the nanoparticles, for example by atomic layer deposition or any other suitable technique. The second protective coating 4 may recoat any surfaces that may have been broken during mechanical agitation or grinding.

The protective coating 4 may provide a barrier to liquids such that the quantum dots do not degrade under high humidity conditions. The protective coating 4 may also passivate the quantum dot surface (i.e., the surface of shell 2, or silica shell 3, or both) such that oxidation of the quantum dots does not occur even if a limited amount of liquid molecules diffuse to the shell 2 or silica shell 3.

After stage 16 in Fig. 4, stage 18 in Fig. 5, or stage 20 in Fig. 5, the product may be particles that are aggregates of individual nanoparticles. The aggregate particles may have an average diameter of at least 100 nm in some embodiments and no more than 100 µm in some embodiments. The aggregate particles may behave like powdered phosphors. Accordingly, the aggregate particles may be integrated into silicone or other binding materials and applied to an LED in an on-chip application, or formed into a structure that may be spaced apart from an LED.

Fig. 6 illustrates one example of a light source including an LED combined with a luminescent nanoparticle material, according to some embodiments. An LED 30 may be attached to a mount 32. The LED 30 may be a III-nitride flip chip device, or any other suitable device. One or more luminescent materials, including a nanoparticle material as described in the examples above, is formed into a luminescent layer 34 disposed in the path of light emitted by LED 30. The luminescent layer 34 may be spaced apart from the LED 30, as illustrated, or may be placed in direct contact with LED 30. The luminescent layer 34 may be formed separately from the LED, or formed in situ with the LED.

Examples of luminescent layers that are formed separately from the LED include ceramic wavelength converting structures, that may be formed by sintering or any other suitable process; wavelength converting materials such as powder phosphors that are disposed in transparent material such as silicone or glass that is rolled, cast, or otherwise formed into a sheet, then singulated into individual wavelength converting structures; and wavelength converting materials such as powder phosphors that are disposed in a transparent material such as silicone that is formed into a flexible sheet, which may be laminated or otherwise disposed over an LED.

Examples of luminescent layers that are formed in situ include luminescent materials that are mixed with a transparent material such as silicone and dispensed, screen printed, stenciled, molded, or otherwise disposed over the LED; and wavelength converting materials that are coated on the LED by electrophoretic, vapor, or any other suitable type of deposition.

Multiple forms of luminescent layers can be used in a single device. As just one example, a ceramic luminescent layer can be combined with a molded luminescent layer, with the same or different wavelength converting materials in the ceramic and the molded members.

In addition to the nanoparticle luminescent materials described above, luminescent layer 34 may include, for example, conventional phosphors, organic phosphors, organic semiconductors, II-VI or III-V semiconductors, dyes, polymers, or other materials that luminesce. Multiple wavelength converting materials may be disposed in the same luminescent layer, or in separate luminescent layers.

The luminescent layer 34 absorbs light emitted by the LED and emits light of one or more different wavelengths. Unconverted light emitted by the LED is often part of the final spectrum of light extracted from the structure, though it need not be. Examples of common combinations include a blue-emitting LED combined with a yellow-emitting luminescent layer, a blue-emitting LED combined with green- and red-emitting luminescent layer(s), a UV-emitting LED combined with blue- and yellow-emitting luminescent layer(s), and a UV-emitting LED combined with blue-, green-, and red-emitting luminescent layer(s). Wavelength converting materials emitting other colors of light may be added to tailor the spectrum of light extracted from the structure.

The embodiments described herein may be incorporated into any suitable light emitting device. Embodiments of the invention are not limited to the particular structures illustrated.

Some features of some embodiments may be omitted or implemented with other embodiments. The device elements and method elements described herein may be interchangeable and used in or omitted from any of the examples or embodiments described herein.

Though in the examples and embodiments described above the semiconductor light emitting device is a III-nitride LED that emits blue or UV light, semiconductor light emitting devices besides LEDs, such as laser diodes, are within the scope of the invention. In addition, the principles described herein may be applicable to semiconductor light emitting or other devices made from other materials systems such as other III-V materials, III-phosphide, III-arsenide, II-VI materials, ZnO, or Si-based materials.

Having described the invention in detail, those skilled in the art will appreciate that, given the present disclosure, modifications may be made to the invention without departing from the scope of the of the invention defined by the appended claims. Therefore, it is not intended that the scope of the invention be limited to the specific embodiments illustrated and described, but by the appended claims.

## Claims

1. A luminescent material comprising particles comprising:
a core (1) of a first semiconductor material, the core (1) showing quantum confinement and having a size in the nanometer range in at least one dimension;
a first shell (2) of a second semiconductor material surrounding the core (1);
a second shell (3) of an insulating material disposed on a surface of the first shell (2); and
a coating (4) disposed on a surface of the second shell (3),
**characterised in that** the coating (4) is a semi-permeable coating (4) having a water vapor transport rate (WVTR) between 10⁻¹ g/m²/day and 10⁻⁴ g/m²/day.

2. The luminescent material of claim 1 wherein the second shell (3) is silica.

3. The luminescent material of claim 1 wherein the coating (4) is one of metal oxide, Al₂O₃, SiO₂, Nb₂O₅, a multilayer structure, and a multilayer of Al₂O₃ and Nb₂O₅.

4. A method comprising:
forming, by atomic layer deposition, a coating of a metal oxide on a plurality of particles showing quantum confinement and having a size in the nanometer range in at least one dimension,
**characterised in that**
the coating is a semi-permeable coating having a water vapor transport rate (WVTR) between 10⁻¹ g/m²/day and 10⁻⁴ g/m²/day.

5. The method of claim 4 further comprising mechanically agitating the plurality of particles to form a powder.

6. The method of claim 5 wherein said mechanically agitating happens prior to said forming a coating, the method further comprising, prior to said mechanically agitating:
dispersing the plurality of particles in a solvent; and
drying the plurality of particles to remove the solvent.

7. The method of claim 5 comprising:
after said mechanically agitating, forming a second semi-permeable coating of a metal oxide on the plurality of particles,
wherein the water vapor transport rate (WVTR) of the semi-permeable coatings is between 10⁻¹ g/m²/day and 10⁻⁴ g/m²/day and the water vapor transport rate (WVTR) of the first coating differs from the water vapor transport rate (WVTR) of the second coating.

8. The method of claim 7 wherein said forming a second coating comprises forming the second coating by atomic layer deposition.

9. The method of claim 4 wherein the coating comprises one of Nb₂O₅, SiO₂ and Al₂O₃.

10. The method of claim 4 further comprising after said forming a coating, disposing the plurality of particles in a path of light emitted by a light emitting diode.

11. A device comprising:
a light emitting diode (LED) (30); and
a luminescent material (34) according to any one of the claims 1-3 disposed in a path of light emitted by the LED.

12. The device of claim 11 wherein the luminescent material is a powder, wherein the powder is mixed with silicone.

## Patentansprüche

1. Lumineszentes Material, welches Partikel umfasst, welche umfassen:
einen Kern (1) aus einem ersten Halbleitermaterial, wobei der Kern (1) Quanteneingrenzung zeigt und eine Größe im Nanometerbereich in mindestens einer Dimension hat;
eine erste Ummantelung (2) aus einem zweiten Halbleitermaterial, welche den Kern (1) umgibt;
eine zweite Ummantelung (3) aus einem Isoliermaterial, die auf einer Oberfläche der ersten Ummantelung (2) angeordnet ist; und
eine Beschichtung (4), die auf einer Oberfläche der zweiten Ummantelung (3) angeordnet ist,
**dadurch gekennzeichnet, dass** die Beschichtung (4) eine semipermeable Beschichtung (4) mit einer Wasserdampfdurchlässigkeit (WVTR) zwischen 10⁻¹ g/m²/Tag und 10⁻⁴ g/m²/Tag ist.

2. Lumineszentes Material nach Anspruch 1, wobei die zweite Ummantelung (3) Siliciumdioxid ist.

3. Lumineszentes Material nach Anspruch 1, wobei die Beschichtung (4) eines von Metalloxid, Al₂O₃, SiO₂, Nb₂O₅, einer Mehrschichtstruktur und einer Mehrschicht aus Al₂O₃ und Nb₂O₅ ist.

4. Verfahren, umfassend:
Bilden einer Beschichtung aus einem Metalloxid auf einer Vielzahl von Partikeln, die Quanteneingrenzung zeigen und eine Größe im Nanometerbereich in mindestens einer Dimension haben, durch Atomschichtabscheidung,
**dadurch gekennzeichnet, dass**
die Beschichtung eine semipermeable Beschichtung mit einer Wasserdampfdurchlässigkeit (WVTR) zwischen 10⁻¹ g/m²/Tag und 10⁻⁴ g/m²/Tag ist.

5. Verfahren nach Anspruch 4, des Weiteren umfassend mechanisches Bewegen der Vielzahl von Partikeln, um ein Pulver zu bilden.

6. Verfahren nach Anspruch 5, wobei das mechanische Bewegen vor dem Bilden einer Beschichtung stattfindet, wobei das Verfahren des Weiteren vor dem mechanischen Bewegen umfasst:
Dispergieren der Vielzahl von Partikeln in dem Lösungsmittel; und
Trocknen der Vielzahl von Partikeln, um das Lösungsmittel zu entfernen.

7. Verfahren nach Anspruch 5, umfassend:
Bilden einer zweiten semipermeablen Beschichtung aus einem Metalloxid auf der Vielzahl der Partikel nach dem mechanischen Bewegen,
wobei die Wasserdampfdurchlässigkeit (WVTR) der semipermeablen Beschichtungen zwischen 10⁻¹ g/m²/Tag und 10⁻⁴ g/m²/Tag liegt und die Wasserdampfdurchlässigkeit (WVTR) der ersten Beschichtung sich von der Wasserdampfdurchlässigkeit (WVTR) der zweiten Beschichtung unterscheidet.

8. Verfahren nach Anspruch 7, wobei das Bilden einer zweiten Beschichtung Bilden der zweiten Beschichtung durch Atomschichtabscheidung umfasst.

9. Verfahren nach Anspruch 4, wobei die Beschichtung eines von Nb₂O₅, SiO₂ und Al₂O₃ umfasst.

10. Verfahren nach Anspruch 4, des Weiteren umfassend Anordnen der Vielzahl von Partikeln in einem Pfad von Licht, das von einer Licht emittierenden Diode emittiert wird, nach dem Bilden einer Beschichtung.

11. Vorrichtung, umfassend:
eine Licht emittierende Diode (LED) (30); und
ein lumineszentes Material (34) nach einem der Ansprüche 1 bis 3, das in einem Pfad von Licht angeordnet ist, welches von der LED emittiert wird.

12. Vorrichtung nach Anspruch 11, wobei das lumineszente Material ein Pulver ist, wobei das Pulver mit Silikon gemischt wird.

## Revendications

1. Matériau luminescent comprenant des particules comprenant :
un noyau (1) d'un premier matériau semi-conducteur, le noyau (1) présentant un confinement quantique et ayant une taille de l'ordre du nanomètre dans au moins une dimension ;
une première enveloppe (2) d'un second matériau semi-conducteur entourant le noyau (1) ;
une seconde enveloppe (3) d'un matériau isolant disposée sur une surface de la première enveloppe (2) ; et
un revêtement (4) disposé sur une surface de la seconde enveloppe (3), **caractérisé en ce que** le revêtement (4) est un revêtement semi-perméable (4) ayant un taux de transport de vapeur d'eau (WVTR) entre 10⁻¹ g/m²/jour et 10⁻⁴ g/m²/jour.

2. Matériau luminescent selon la revendication 1, la seconde enveloppe (3) étant de la silice.

3. Matériau luminescent selon la revendication 1, le revêtement (4) étant l'un des oxydes métalliques, Al₂O₃, SiO₂, Nb₂O₅, une structure multicouche, et une multicouche de Al₂O₃ et Nb₂O₅.

4. Procédé comprenant :
la formation, par dépôt de couche atomique, d'un revêtement d'un oxyde métallique sur une pluralité de particules présentant un confinement quantique et ayant une taille de l'ordre du nanomètre dans au moins une dimension,
**caractérisé en ce que**
le revêtement est un revêtement semi-perméable ayant un taux de transport de vapeur d'eau (WVTR) compris entre 10⁻¹ g/m²/jour et 10⁻⁴ g/m²/jour.

5. Procédé selon la revendication 4, comprenant en outre l'agitation mécanique de la pluralité de particules pour former une poudre.

6. Procédé selon la revendication 5, ladite agitation mécanique se produisant avant ladite formation d'un revêtement, le procédé comprenant en outre, avant ladite agitation mécanique :
la dispersion de la pluralité de particules dans un solvant ; et
le séchage de la pluralité de particules pour éliminer le solvant.

7. Procédé selon la revendication 5 comprenant :
après ladite agitation mécanique, la formation d'un second revêtement semi-perméable d'un oxyde métallique sur la pluralité de particules,
le taux de transport de vapeur d'eau (WVTR) des revêtements semi-perméables étant compris entre 10⁻¹ g/m²/jour et 10⁻⁴ g/m²/jour et le taux de transport de vapeur d'eau (WVTR) du premier revêtement différant du taux de transport de vapeur d'eau (WVTR) du second revêtement.

8. Procédé selon la revendication 7 ladite formation d'un second revêtement comprenant la formation du second revêtement par dépôt de couche atomique.

9. Procédé selon la revendication 4, le revêtement comprenant un élément parmi Nb₂O₅, SiO₂ et Al₂O₃.

10. Procédé selon la revendication 4, comprenant en outre, après ladite formation d'un revêtement, le dépôt de la pluralité de particules dans un chemin de lumière émise par une diode électroluminescente.

11. Dispositif comprenant :
une diode électroluminescente (LED) (30) ; et
un matériau luminescent (34) selon l'une quelconque des revendications 1 à 3 disposé dans un chemin de lumière émise par la LED.

12. Dispositif selon la revendication 11, le matériau luminescent étant une poudre, la poudre étant mélangée à du silicone.
